(19) Europäisches Patentamt
European Patent Office
Office européen des brevets

(11) **EP 1 902 472 B1**

(12) **EUROPEAN PATENT SPECIFICATION**

(45) Date of publication and mention
of the grant of the patent:
**21.07.2010 Bulletin 2010/29**

(51) Int Cl.:
*H01L 29/78* (2006.01)        *H01L 29/51* (2006.01)
*H01L 29/15* (2006.01)

(21) Application number: **06752162.5**

(22) Date of filing: **02.05.2006**

(86) International application number:
**PCT/US2006/016998**

(87) International publication number:
**WO 2006/127225 (30.11.2006 Gazette 2006/48)**

(54) **SEMICONDUCTOR DEVICE COMPRISING A SUPERLATTICE DIELECTRIC INTERFACE LAYER**

HALBLEITERBAUELEMENT MIT EINER DIELEKTRISCHEN SUPERGITTER-GRENZFLÄCHENSCHICHT

DISPOSITIF A SEMI-CONDUCTEURS COMPRENANT UNE COUCHE D'INTERFACE DIELECTRIQUE A SUPERPOSITION

(84) Designated Contracting States:
**DE FR GB IT**

(30) Priority: **25.05.2005 US 136881**

(43) Date of publication of application:
**26.03.2008 Bulletin 2008/13**

(73) Proprietor: **Mears Technologies, Inc.**
**Waltham, MA 02451 (US)**

(72) Inventors:
• **MEARS, Robert**
**Wellesley, MA 02482 (US)**
• **HYTHA, Marek**
**Brookline, MA 02446 (US)**
• **KREPS, Scott, A.**
**Waltham, MA 02451 (US)**
• **STEPHENSON, Robert, John**
**Newton Upper Falls, MA 02464-1226 (US)**
• **YIPTONG, Jean, Austin, Chan, S.F.**
**Worcester Ma 01604 (US)**
• **DUKOVSKI, Ilija**
**Newton, MA 02460 (US)**

• **RAO, Kalipatnam, Vivek**
**Grafton, MA 0159 (US)**
• **HALILOV, Samed**
**Waltham, MA 02452 (US)**
• **HUANG, Xiangyang**
**Waltham, MA 02452 (US)**

(74) Representative: **Ferreccio, Rinaldo et al**
**c/o Botti & Ferrari S.r.l.**
**Via Locatelli 5**
**20124 Milano (IT)**

(56) References cited:
WO-A-00/67331          WO-A-2005/004241
WO-A-2005/018005       JP-A- 63 181 473
US-A- 4 697 197        US-B1- 6 559 014

• WILK G D ET AL: "High-[kappa] gate dielectrics: Current status and materials properties considerations" JOURNAL OF APPLIED PHYSICS, AMERICAN INSTITUTE OF PHYSICS. NEW YORK, US, vol. 89, no. 10, 15 May 2001 (2001-05-15), pages 5243-5275, XP002406769 ISSN: 0021-8979

EP 1 902 472 B1

**Description**

**Field of the Invention**

The present invention relates to the field of semiconductors, and, more particularly, to semiconductors having enhanced properties based upon energy band engineering and associated methods.

**Background of the Invention**

Structures and techniques have been proposed to enhance the performance of semiconductor devices, such as by enhancing the mobility of the charge carriers. For example, U.S. Patent Application No. 2003/0057416 to Currie et al. discloses strained material layers of silicon, silicon-germanium, and relaxed silicon and also including impurity-free zones that would otherwise cause performance degradation. The resulting biaxial strain in the upper silicon layer alters the carrier mobilities enabling higher speed and/or lower power devices. Published U.S. Patent Application No. 2003/0034529 to Fitzgerald et al. discloses a CMOS inverter also based upon similar strained silicon technology.

U.S. Patent No. 6,472, 685 B2 to Takagi discloses a semiconductor device including a silicon and carbon layer sandwiched between silicon layers so that the conduction band and valence band of the second silicon layer receive a tensile strain. Electrons having a smaller effective mass, and which have been induced by an electric field applied to the gate electrode, are confined in the second silicon layer, thus, an n-channel MOSFET is asserted to have a higher mobility.

U.S. Patent No. 4,937,204 to Ishibashi et al. discloses a superlattice in which a plurality of layers, less than eight monolayers, and containing a fraction or a binary compound semiconductor layers, are alternately and epitaxially grown. The direction of main current flow is perpendicular to the layers of the superlattice.

U.S. Patent No. 5,357,119 to Wang et al. discloses a Si-Ge short period superlattice with higher mobility achieved by reducing alloy scattering in the superlattice. Along these lines, U.S. Patent No. 5,683,934 to Candelaria discloses an enhanced mobility MOSFET including a channel layer comprising an alloy of silicon and a second material substitutionally present in the silicon lattice at a percentage that places the channel layer under tensile stress.

U.S. Patent No. 5,216,262 to Tsu discloses a quantum well structure comprising two barrier regions and a thin epitaxially grown semiconductor layer sandwiched between the barriers. Each barrier region consists of alternate layers of $SiO_2$/Si with a thickness generally in a range of two to six monolayers. A much thicker section of silicon is sandwiched between the barriers.

An article entitled "Phenomena in silicon nanostructure devices" also to Tsu and published online September 6, 2000 by Applied Physics and Materials Science & Processing, pp. 391-402 discloses a semiconductor-atomic superlattice (SAS) of silicon and oxygen. The Si/O superlattice is disclosed as useful in a silicon quantum and light-emitting devices. In particular, a green electromuminescence diode structure was constructed and tested. Current flow in the diode structure is vertical, that is, perpendicular to the layers of the SAS. The disclosed SAS may include semiconductor layers separated by adsorbed species such as oxygen atoms, and CO molecules. The silicon growth beyond the adsorbed monolayer of oxygen is described as epitaxial with a fairly low defect density. One SAS structure included a 1.1 nm thick silicon portion that is about eight atomic layers of silicon, and another structure had twice this thickness of silicon. An article to Luo et al. entitled "Chemical Design of Direct-Gap Light-Emitting Silicon" published in Physical Review Letters, Vol. 89, No. 7 (August 12, 2002) further discusses the light emitting SAS structures of Tsu.

Published International Application "WO 02/103,767 A1 to Wang, Tsu and Lofgren, discloses a barrier building block of thin silicon and oxygen, carbon, nitrogen, phosphorous, antimony, arsenic or hydrogen to thereby reduce current flowing vertically through the lattice more than four orders of magnitude. The insulating layer/barrier layer allows for low defect epitaxial silicon to be deposited next to the insulating layer.

Published Great Britain Patent Application 2,347,520 to Mears et al. discloses that principles of Aperiodic Photonic Band-Gap (APBG) structures may be adapted for electronic bandgap engineering. In particular, the application discloses that material parameters, for example, the location of band minima, effective mass, etc, can be tailored to yield new aperiodic materials with desirable band-structure characteristics. Other parameters, such as electrical conductivity, thermal conductivity and dielectric permittivity or magnetic permeability are disclosed as also possible to be designed into the material.

Despite considerable efforts at materials engineering to increase the mobility of charge carriers in semiconductor devices, there is still a need for greater improvements. Greater mobility may increase device speed and/or reduce device power consumption. With greater mobility, device performance can also be maintained despite the continued shift to smaller device features. Moreover, there is a need for structures which provide enhanced mobility adjacent dielectric layer interfaces, particularly in applications where high-K dielectrics are used.

## Summary of the Invention

In view of the foregoing background, it is therefore an object of the present invention to provide a semiconductor device including a superlattice which provides a dielectric interface for reducing scattering, for example.

This and other objects, features, and advantages in accordance with the present invention are provided by a semiconductor device as claimed in claim 1, which includes a semiconductor substrate and at least one active device adjacent the semiconductor substrate. More particularly, the at least one active device includes an electrode layer, a high-K dielectric layer underlying the electrode layer and in contact therewith, and a superlattice underlying the high-K dielectric layer opposite the electrode layer and in contact with the high-K dielectric layer. The superlattice includes a plurality of stacked groups of layers. Moreover, each group of layers of the superlattice includes a plurality of stacked base semiconductor monolayers defining a base semiconductor portion and at least one non-semiconductor monolayer constrained within a crystal lattice of adjacent base semiconductor portions. A method for manufacturing the device is claimed in claim 15.

The superlattice advantageously acts as an interface for the high-K dielectric layer which provides reduced scattering and, thus, enhanced mobility with respect to prior art insulation layers such as silicon oxides used with high-K dielectrics. Moreover, use of the superlattice as an insulator for applications using high-K dielectrics may result in smaller overall thicknesses, and thus improved device capacitance.

More particularly, the high-K dielectric layer may have a dielectric constant of greater than about five and, more particularly, greater than about ten or twenty, for example. Further, the at least one non-semiconductor monolayer may be less than about five monolayers to thereby function as an energy band-modifying layer. By way of example, the high-K dielectric layer may comprise at least one of silicon oxide, zirconium oxide, and hafnium oxide.

The at least one active device further includes a channel region underlying the superlattice, as well as source and drain regions adjacent the channel region. Furthermore, the base semiconductor may comprise silicon, and the at least one non-semiconductor monolayer may comprise oxygen. More particularly, the at least one non-semiconductor monolayer may be a non-semiconductor selected from the group consisting of oxygen, nitrogen, fluorine, and carbon-oxygen.

The at least one non-semiconductor monolayer may be a single monolayer thick, and each base semiconductor portion may be less than eight monolayers thick, for example. Furthermore, in some embodiments all of the base semiconductor portions may be a.same number of monolayers thick. In other embodiments, at least some of the base semiconductor portions may be a different number of monolayers thick. Moreover, opposing base semiconductor monolayers in adjacent groups of layers of the superlattice are chemically bound together.

## Brief Description of the Drawings

FIG. 1 is schematic cross-sectional diagram of a semiconductor device in accordance with the present invention including a superlattice.

FIG. 2 is a greatly enlarged schematic cross-sectional view of the superlattice as shown in FIG. 1.

FIG. 3 is a perspective schematic atomic diagram of a portion of the superlattice shown in FIG. 1.

FIG. 4 is a greatly enlarged schematic cross-sectional view of another embodiment of a superlattice that may be used in the device of FIG. 1.

FIG. 5A is a graph of the calculated band structure from the gamma point (G) for both bulk silicon as in the prior art, and for the 4/1 Si/O superlattice as shown in FIGS. 1-3.

FIG. 5B is a graph of the calculated band structure from the Z point for both bulk silicon as in the prior art, and for the 4/1 Si/O superlattice as shown in FIGS. 1-3.

FIG. 5C is a graph of the calculated band structure from both the gamma and Z points for both bulk silicon as in the prior art, and for the 5/1/3/1 Si/O superlattice as shown in FIG. 4.

FIGS. 6A-6C are a series of schematic cross-sectional diagrams illustrating a method for making the semiconductor device of FIG. 1.

## Detailed Description of the Preferred Embodiments

The present invention will now be described more fully hereinafter with reference to the accompanying drawings, in which preferred embodiments of the invention are shown: This invention may, however, be embodied in many different forms and should not be construed as limited to the embodiments set forth herein. Rather, these embodiments are provided so that this disclosure will be thorough and complete, and will fully convey the scope of the invention to those skilled in the art. Like numbers refer to like elements throughout, and prime notation is used to indicate similar elements in alternate embodiments.

The present invention relates to controlling the properties of semiconductor materials at the atomic or molecular level to achieve improved performance within semiconductor devices. Further, the invention relates to the identification, creation, and use of improved, materials for use in the conduction paths of semiconductor devices.

Applicants theorize, without wishing to be bound thereto, that certain superlattices as described herein reduce the effective mass of charge carriers and that this thereby leads to higher charge carrier mobility. Effective mass is described with various definitions in the literature. As a measure of the improvement in effective mass Applicants use a "conductivity reciprocal effective mass tensor", $\mathbf{M}_e^{-1}$ and $\mathbf{M}_h^{-1}$ for electrons and holes respectively, defined as:

$$\mathbf{M}_{e,ij}^{-1}(E_F,T) = \frac{\sum\limits_{E>E_F} \int\limits_{B.Z.} \left(\nabla_{\mathbf{k}} E(\mathbf{k},n)\right)_i \left(\nabla_{\mathbf{k}} E(\mathbf{k},n)\right)_j \frac{\partial f(E(\mathbf{k},n),E_F,T)}{\partial E} d^3\mathbf{k}}{\sum\limits_{E>E_F} \int\limits_{B.Z.} f(E(\mathbf{k},n),E_F,T) d^3\mathbf{k}}$$

for electrons and:

$$\mathbf{M}_{h,ij}^{-1}(E_F,T) = \frac{-\sum\limits_{E<E_F} \int\limits_{B.Z.} \left(\nabla_{\mathbf{k}} E(\mathbf{k},n)\right)_i \left(\nabla_{\mathbf{k}} E(\mathbf{k},n)\right)_j \frac{\partial f(E(\mathbf{k},n),E_F,T)}{\partial E} d^3\mathbf{k}}{\sum\limits_{E<E_F} \int\limits_{B.Z.} (1 - f(E(\mathbf{k},n),E_F,T)) d^3\mathbf{k}}$$

for holes, where $f$ is the Fermi-Dirac distribution, $E_F$ is the Fermi energy, T is the temperature, E(k,n) is the energy of an electron in the state corresponding to wave vector k and the nth energy band, the indices i and j refer to Cartesian coordinates x, y and z, the integrals are taken over the Brillouin zone (B.Z.), and the summations are taken over bands with energies above and below the Fermi energy for electrons and holes respectively.

Applicants' definition of the conductivity reciprocal effective mass tensor is such that a tonsorial component of the conductivity of the material is greater for greater values of the corresponding component of the conductivity reciprocal effective mass tensor. Again Applicants theorize without wishing to be bound thereto that the superlattices described herein set the values of the conductivity reciprocal effective mass tensor so as to enhance the conductive properties of the material, such as typically for a preferred direction of charge carrier transport. The inverse of the appropriate tensor element is referred to as the conductivity effective mass. In other words, to characterize semiconductor material structures, the conductivity effective mass for electrons/holes as described above and calculated in the direction of intended carrier transport is used to distinguish improved materials.

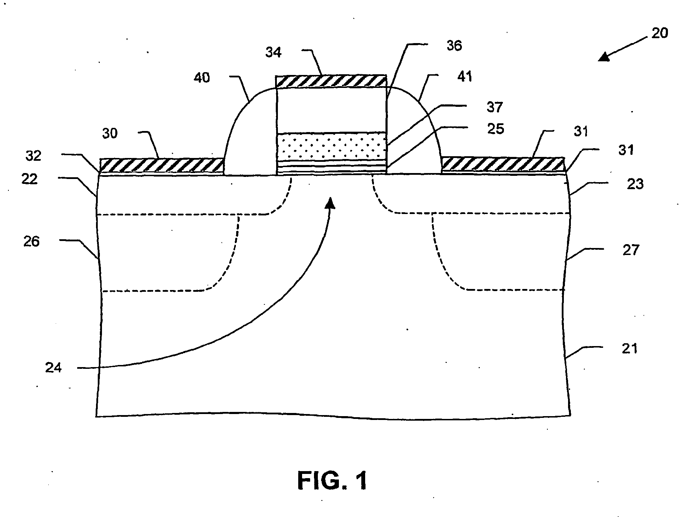

Using the above-described measures, one can select materials having improved band structures for specific purposes. One such example would be a superlattice 25 material as a dielectric interface layer in a semiconductor device. A planar MOSFET 20 including the superlattice 25 in accordance with the invention is first described with reference to FIG. 1. One skilled in the art, however, will appreciate that the materials identified herein could be used in many different types of semiconductor devices, such as discrete devices and/or integrated circuits. By way of example, another application in which the superlattice 25 may be used as a dielectric interface layers is FINFETs.

In particular, as the trend toward ever-smaller FET devices continues, the use of high-K gate dielectric materials becomes more attractive. This is because traditional gate dielectric materials such as silicon dioxide ($SiO_2$) tend to cause leakage if they are overly thinned in an attempt to reduce device size. Yet, placing a high-K material directly in contact with the device channel may lead to other problems, such as "bleeding" of the high-K material into the channel. As a result, in most applications where high-K gate dielectrics are used, an interfacial $SiO_2$ layer is deposited between the channel region and the high-K material. However, this potentially offsets the size reduction achieved by using the thin high-K material to some extent, and may also reduce device capacitance. Moreover, undesirable scattering may occur at the $SiO_2$/high-K interface.

The illustrated MOSFET 20 includes a substrate 21, lightly doped source/drain extension regions 22, 23, more heavily doped source/drain regions 26, 27, and a channel region 24 therebetween. The superlattice 25 overlies the channel region 24 and is in contact therewith. A gate dielectric layer 37 (which is shown with stippling for clarity of illustration in FIG. 1) is on the superlattice **25,** and a gate electrode layer **36** is on the gate dielectric layer and opposite the superlattice. Sidewall spacers **40, 41** are also provided in the illustrated MOSFET **20,** as well as silicide layers **30, 31,** and **34** on the lightly doped source and drain regions **22, 23** and the gate electrode layer **36,** respectively.

The superlattice **25** advantageously acts as an interface for the gate dielectric layer **37** which provides reduced scattering and, thus, enhanced mobility with respect to prior art insulation layers such as silicon oxides used with high-K dielectrics. Moreover, use of the superlattice **25** as an insulator for applications using high-K dielectrics may result in smaller overall thicknesses, and thus improved device capacitance. This is because the superlattice **25** may be formed in relatively small thicknesses yet still provide desired insulating properties, as will be discussed further below.

The gate dielectric layer **37** preferably comprises a high-K dielectric having a dielectric constant of greater than about five and, more preferably, greater than about ten or twenty. By way of example, the gate dielectric layer may comprise one or more of $BaSrTiO_3$ (k=300), $Ta_2O_5$ (k=26) Zr02 (k=25), $HfO_2$ (k=24.5), $Al_2O_3$ (k=9), and $Si_3N_4$ (k=7), although other suitable high-K dielectric materials may also be used.

Applicants have identified improved materials or structures for the superlattice **25** of the MOSFET **20.** More specifically, the Applicants have identified materials or structures having energy band structures for which the appropriate conductivity effective masses for electrons and/or holes are substantially less than the corresponding values for silicon.

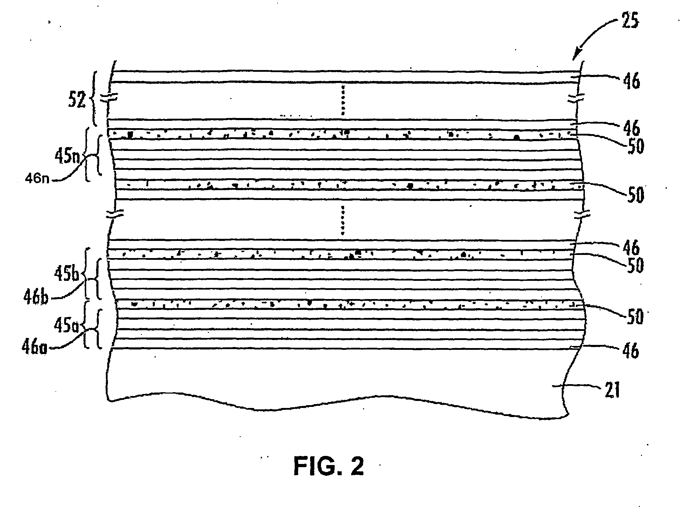

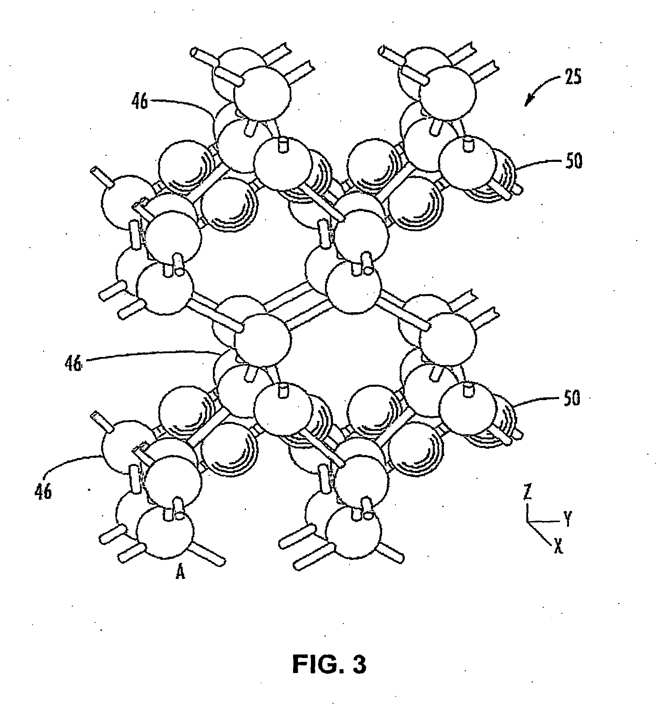

Referring now additionally to FIGS. 2 and 3, the materials or structures are in the form of a superlattice **25** whose structure is controlled at the atomic or molecular level and may be formed using known techniques of atomic or molecular layer deposition. The superlattice **25** includes a plurality of layer groups **45a-45n** arranged in stacked relation, as perhaps best understood with specific reference to the schematic cross-sectional view of FIG. 2.

Each group of layers **45a-45n** of the superlattice **25** illustratively includes a plurality of stacked base semiconductor monolayers **46** defining a respective base semiconductor portion **46a-46n** and an energy band-modifying layer **50** thereon. The energy band-modifying layers **50** are indicated by stippling in FIG. 2 for clarity of illustration.

The energy-band modifying layer **50** illustratively includes one non-semiconductor monolayer constrained within a crystal lattice of adjacent base semiconductor portions. That is, opposing base semiconductor monolayers **46** in adjacent groups of layers **45a-45n** are chemically bound together. For example, in the case of silicon monolayers **46,** some of the silicon atoms in the upper or top semiconductor monolayer of the group of monolayers **46a** will be covalently bonded with silicon atoms in the lower or bottom monolayer of the group **46b.** This allows the crystal lattice to continue through the groups of layers despite the presence of the non-semiconductor monolayer(s) (e.g., oxygen monolayer(s)). Of course, there will not be a complete or pure covalent bond between the opposing silicon layers **46** of adjacent groups **45a-45n** as some of the silicon atoms in each of these layers will be bonded to non-semiconductor atoms (i.e., oxygen in the present example), as will be appreciated by those skilled in the art.

In other embodiments, more than one non-semiconductor layer monolayer may be possible. By way of example, the number of non-semiconductor monolayers in the energy band-modifying layer **50** may preferably be less than about five monolayers to thereby provide the desired energy band-modifying properties.

It should be noted that reference herein to a non-semiconductor or semiconductor monolayer means that the material used for the monolayer would be a non-semiconductor or semiconductor if formed in bulk. That is, a single monolayer of a material, such as semiconductor, may not necessarily exhibit the same properties that it would if formed in bulk or in a relatively thick layer, as will be appreciated by those skilled in the art.

Applicants theorize without wishing to be bound thereto that energy band-modifying layers **50** and adjacent base semiconductor portions **46a-46n** cause the superlattice **25** to have a lower appropriate conductivity effective mass for the charge carriers in the parallel layer direction than would otherwise be present. Considered another way, this parallel direction is orthogonal to the stacking direction. The band modifying layers **50** may also cause the superlattice **25** to have a common energy band structure, while also advantageously functioning as an insulator between layers or regions vertically above and below the superlattice.

Moreover, this structure may also advantageously act as a barrier to dopant and/or material bleed between layers vertically above and below the superlattice **25.** These properties may thus advantageously allow the superlattice **25** to provide an interface for high-K dielectrics which not only reduces bleeding of the high-K material into the channel region, but which may also advantageously reduce unwanted scattering effects and improve device mobility, as will be appreciated by those skilled in the art.

It is also theorized that a semiconductor device, such as the illustrated MOSFET **20,** will enjoy a higher charge carrier mobility based upon the lower conductivity effective mass than would otherwise be present. In some embodiments, and as a result of the band engineering achieved by the present invention, the superlattice **25** may further have a substantially direct energy bandgap that may be particularly advantageous for opto-electronic devices, for example, as described in further detail below. Of course, all of the above-described properties of the superlattice **25** need not be utilized in every application. For example, in some applications the superlattice **25** may only be used for its dopant blocking/insulation properties or its enhanced mobility, or it may be used for both in other applications, as will be appreciated by those skilled in the art.

Moreover, because of the above-described lower appropriate conductivity effective mass for the charge carriers in the parallel layer direction, in some embodiments the superlattice **25** may also advantageously be used to provide the channel region **24.** That is, the illustrated superlattice **25** may be formed of a sufficient thickness so that lower.groups of layers **45** may be used as the channel, while upper groups of layers may provide the high-K dielectric interface. Alternately, respective superlattice layers may be formed for these purposes. Further details on using such a superlattice as a channel in a semiconductor device are provided in U.S. patent application US 2002/262,597, which is assigned to the present Assignee and is hereby incorporated in its entirety by reference, for example.

In such embodiments where the channel **24** comprises a superlattice in accordance with the invention, the source/drain regions **22, 23** and gate **35** of the MOSFET **20** may be considered as regions for causing the transport of charge carriers through the superlattice in a parallel direction relative to the layers of the stacked groups **45a-45a.** Other such regions are also contemplated by the present invention.

The superlattice **25** also illustratively includes a cap layer **52** on an upper layer group **45n.** The cap layer **52** may comprise a plurality of base semiconductor monolayers **46.** The cap layer **52** may have between 2 to 100 monolayers of the base semiconductor, and, more preferably between 10 to 50 monolayers.

Each base semiconductor portion **46a-46n** may comprise a base semiconductor selected from the group consisting of Group IV semiconductors, Group III-V semiconductors, and Group II-VI semiconductors. Of course, the term Group IV semiconductors also includes Group IV-IV semiconductors, as will be appreciated by those skilled in the art. More particularly, the base semiconductor may comprise at least one of silicon and germanium, for example.

Each energy band-modifying layer **50** may comprise a non-semiconductor selected from the group consisting of oxygen, nitrogen, fluorine, and carbon-oxygen, for example. The non-semiconductor is also desirably thermally stable through deposition of a next layer to thereby facilitate manufacturing. In other embodiments, the non-semiconductor may be another inorganic or organic element or compound that is compatible with the given semiconductor processing as will be appreciated by those skilled in the art.

It should be noted that the term "monolayer" is meant to include a single atomic layer and also a single molecular layer. It is also noted that the energy band-modifying layer **50** provided by a single monolayer is also meant to include a monolayer wherein not all of the possible sites are occupied. For example, with particular reference to the atomic diagram of FIG. 3, a 4/1 repeating structure is illustrated for silicon as the base semiconductor material, and oxygen as the energy band-modifying material. Only half of the possible sites for oxygen are occupied.

In other embodiments and/or with different materials this one half occupation would not necessarily be the case as will be appreciated by those skilled in the art. Indeed it can be seen even in this schematic diagram, that individual atoms of oxygen in a given monolayer are not precisely aligned along a flat plane as will also be appreciated by those of skill in the art of atomic deposition. By way of example, a preferred occupation range is from about one-eighth to one-half of the possible oxygen sites being full, although other numbers may be used in certain embodiments.

Silicon and oxygen are currently widely used in conventional semiconductor processing, and, hence, manufacturers will be readily able to use these materials as described herein. Atomic or monolayer deposition is also now widely used. Accordingly, semiconductor devices incorporating the superlattice 25 in accordance with the invention may be readily adopted and implemented, as will be appreciated by those skilled in the art.

It is theorized without Applicants wishing to be bound thereto, that for a superlattice, such as the Si/O superlattice, for example, that the number of silicon monolayers should desirably be seven or less so that the energy band of the superlattice is common or relatively uniform throughout to achieve the desired advantages. The 4/1 repeating structure shown in FIGS. 2 and 3, for Si/O has been modeled to indicate an enhanced mobility for electrons and holes in the X direction. For example, the calculated conductivity effective mass for electrons (isotropic for bulk silicon) is 0.26 and for the 4/1 SiO superlattice in the X direction it is 0.12 resulting in a ratio of 0.46. Similarly, the calculation for holes yields values of 0.36 for bulk silicon and 0.16 for the 4/1 Si/O superlattice resulting in a ratio of 0.44.

While such a directionally preferential feature may be desired in certain semiconductor devices, other devices may benefit from a more uniform increase in mobility in any direction parallel to the groups of layers. It may also be beneficial to have an increased mobility for both electrons and holes, or just one of these types of charge carriers as will be appreciated by those skilled in the art.

The lower conductivity effective mass for the 4/1 Si/O embodiment of the superlattice 25 may be less than two-thirds the conductivity effective mass than would otherwise occur; and this applies for both electrons and holes. Of course, the superlattice 25 may further comprise at least one type of conductivity dopant therein, as will also be appreciated by those skilled in the art. It may be especially appropriate to dope some portion of the superlattice **25** if the superlattice is to provide a portion of the channel, for example.

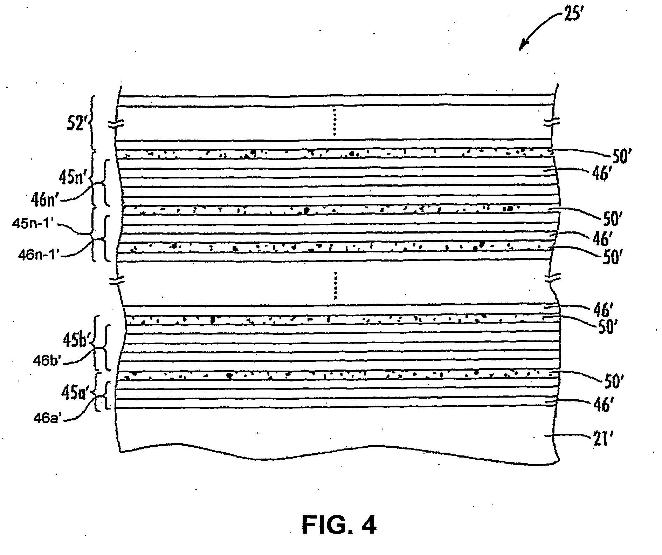

Referring now additionally to FIG. 4, another embodiment of a superlattice **25'** in accordance with the invention having different properties is now described. In this embodiment, a repeating pattern of 3/1/5/1 is illustrated. More particularly, the lowest base semiconductor portion **46a'** has three monolayers, and the second lowest base semiconductor portion **46b'** has five monolayers. This pattern repeats throughout the superlattice **25'.** The energy band-modifying layers 50' may each include a single monolayer. For such a superlattice **25'** including Si/O, the enhancement of charge carrier mobility is independent of orientation in the plane of the layers. Those other elements of FIG. 4 not specifically mentioned are similar to those discussed above with reference to FIG. 2 and need no further discussion herein.

In some device embodiments, all of the base semiconductor portions **46a-46n** of a superlattice **25** may be a same number of monolayers thick. In other embodiments, at least some of the base semiconductor portions **46a-46n may** be a different number of monolayers thick. In still other embodiments, all of the base semiconductor portions **46a-46n** may be a different number of monolayers thick.

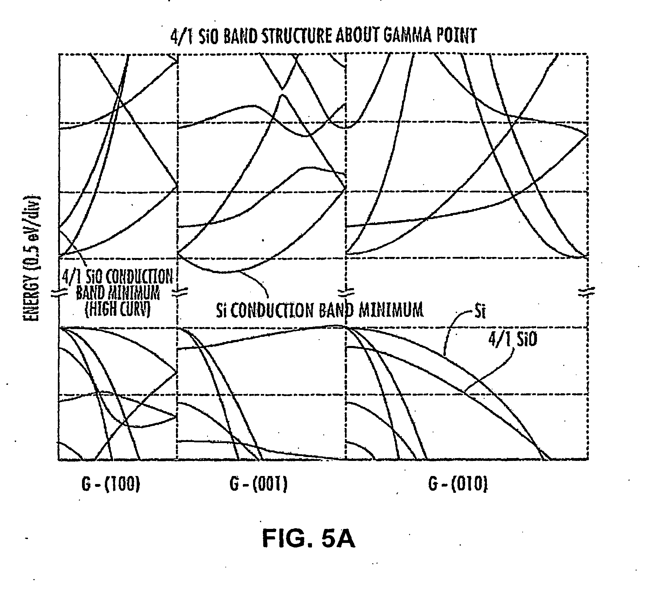

In FIGS. 5A-5C band structures calculated using Density Functional Theory (DFT) are presented. It is well known in the art that DFT underestimates the absolute value of the bandgap. Hence all bands above the gap may be shifted by an appropriate "scissors correction." However the shape of the band is known to be much more reliable. The vertical energy axes should be interpreted in this light.

FIG. 5A shows the calculated band structure from the gamma point (G) for both bulk silicon (represented by continuous lines) and for the 4/1 Si/O superlattice **25** as shown in FIGS. 1-3 (represented by dotted lines). The directions refer to the unit cell of the 4/1 Si/O structure and not to the conventional unit cell of Si, although the (001) direction in the figure does correspond to the (001) direction of the conventional unit cell of Si, and, hence, shows the expected location of the Si conduction band minimum. The (100) and (010) directions in the figure correspond to the (110) and (-110) directions of the conventional Si unit cell. Those skilled in the art will appreciate that the bands of Si on the figure are folded to represent them on the appropriate reciprocal lattice directions for the 4/1 Si/O structure.

It can be seen that the conduction band minimum for the 4/1 Si/O structure is located at the gamma point in contrast to bulk silicon (Si), whereas the valence band minimum occurs at the edge of the Brillouin zone in the (001) direction which we refer to as the Z point. One may also note the greater curvature of the conduction band minimum for the 4/1 Si/O structure compared to the curvature of the conduction band minimum for Si owing to the band splitting due to the perturbation introduced by the additional oxygen layer.

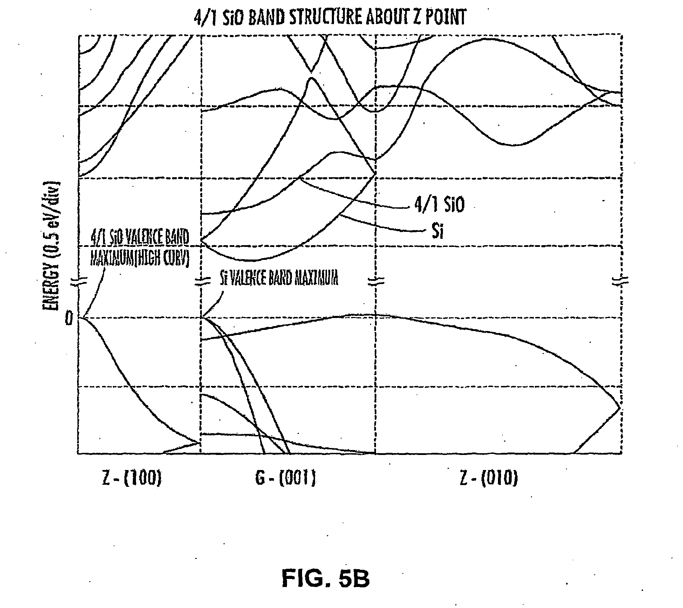

FIG. 5B shows the calculated band structure from the Z point for both bulk silicon (continuous lines) and for the 4/1 Si/O superlattice **25** (dotted lines). This figure illustrates the enhanced curvature of the valence band in the (100) direction.

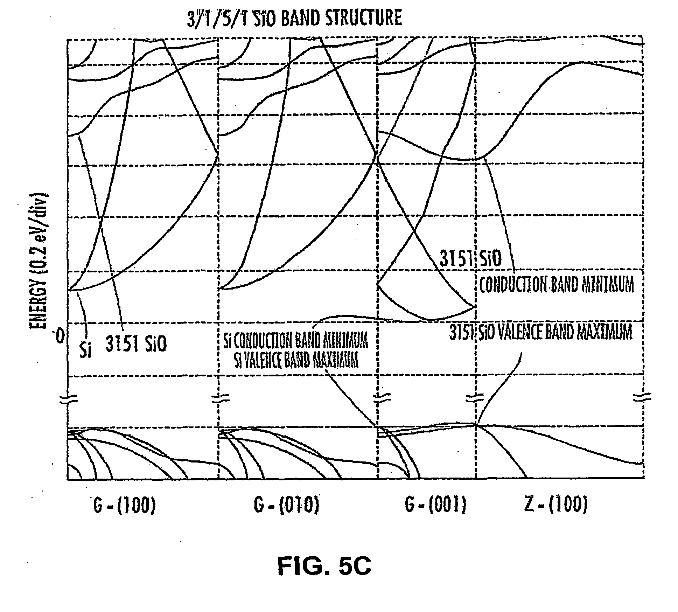

FIG. 5C shows the calculated band structure from both the gamma and Z point for both bulk silicon (continuous lines) and for the 5/1/3/1 Si/O structure of the superlattice **25'** of FIG. 4 (dotted lines). Due to the symmetry of the 5/1/3/1 Si/O structure, the calculated band structures in the (100) and (010) directions are equivalent. Thus the conductivity effective mass and mobility are expected to be isotropic in the plane parallel to the layers, i.e. perpendicular to the (001) stacking direction. Note that in the 5/1/3/1 Si/O example the conduction band minimum and the valence band maximum are both at or close to the Z point.

Although increased curvature is an indication of reduced effective mass, the appropriate comparison and discrimination may be made via the conductivity reciprocal effective mass tensor calculation. This leads Applicants to further theorize that the 5/1/3/1 superlattice **25'** should be substantially direct bandgap. As will be understood by those skilled in the art, the appropriate matrix element for optical transition is another indicator of the distinction between direct and indirect bandgap behavior.

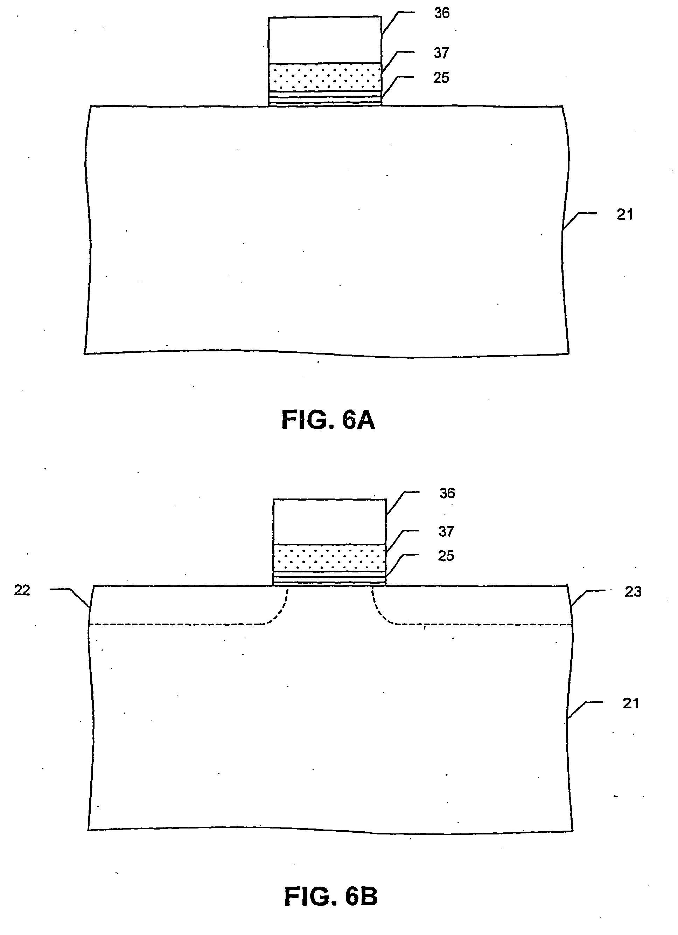

Referring now additionally to FIGS. 6A-6E, a method for making the MOSFET **20** will now be described. The method begins with providing the silicon substrate **21**. By way of example, the substrate may be an eight-inch wafer **21** of lightly doped P-type or N-type single crystal silicon with <100> orientation, although other suitable substrates may also be used. In accordance with the present example, a layer of the superlattice **25** material is then formed across the upper surface of the substrate **21.**

More particularly, the superlattice **25** material is deposited across the surface of the substrate **21** using atomic layer deposition and the epitaxial silicon cap layer **52** is formed, as discussed previously above, and the surface is planarized. It should be noted that in some embodiments the superlattice **25** material may be selectively deposited in desired areas, rather than across the entire substrate **21,** as will be appreciated by those skilled in the art. Moreover, planarization may not be required in all embodiments.

The epitaxial silicon cap layer **52** may have a preferred thickness to prevent superlattice consumption during gate oxide growth, or any other subsequent oxidations, while at the same time reducing or minimizing the thickness of the silicon cap layer to reduce any parallel path of conduction with the superlattice. According to the well-known relationship of consuming approximately 45% of the underlying silicon for a given oxide grown, the silicon cap layer may be greater than 45% of the grown gate oxide thickness plus a small incremental amount to account for manufacturing tolerances known to those skilled in the art. For the present example, and assuming growth of a 25 angstrom gate, one may use approximately 13-15 angstroms of silicon cap thickness.

Once formation of the superlattice 25 is completed, the gate dielectric layer 37 and the gate electrode layer **36** are formed. More particularly, the high-K material is deposited, and steps of poly deposition, patterning, and etching are performed to provide the gate stack illustrated in FIG. 6A. Poly deposition refers to low-pressure chemical vapor deposition (LPCVD) of silicon onto an oxide (hence it forms a polycrystalline material). The step includes doping with P+ or As- to make it conducting, and the layer may be around 250 nm thick, for example.

In addition, the pattern step may include performing a spinning photoresist, baking, exposure to light (i.e., a photolithography step), and developing the resist. Usually, the pattern is then transferred to another layer (oxide or nitride) which acts as an etch mask during the etch step. The etch step typically is a plasma etch (anisotropic, dry etch) that is material selective (e.g., etches silicon ten times faster than oxide) and transfers the lithography pattern into the material of interest.

The superlattice **25** material may be etched using known semiconductor processing techniques. However, it should be noted that with the non-semiconductor present in the superlattice **25**, e.g., oxygen, the superlattice may be more easily etched using an etchant formulated for oxides rather than silicon. Of course, the appropriate etch for a given implementation will vary based upon the structure and materials used for the superlattice **25** and substrate **21**, as will be appreciated by those of skill in the art.

In FIG. 6B, the lightly doped source and drain ("LDD") extensions **22, 23** are formed. These regions are formed using n-type or p-type LDD implantation, annealing, and cleaning. An anneal step may be used after the LDD implantation, but depending on the specific process, it may be omitted. The clean step is a chemical etch to remove metals and organics prior to depositing an oxide layer.

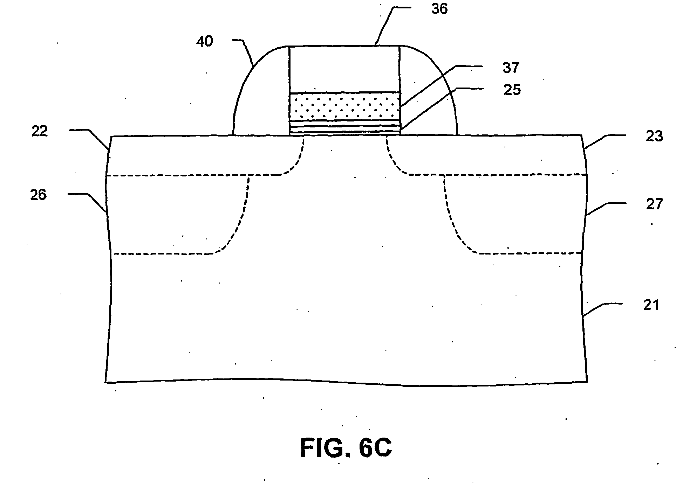

FIG. 6C shows the formation of the sidewall spacers **40, 41** and the source and drain **26, 27** implants. An $SiO_2$ mask may be deposited and etched back for this purpose. N-type or p-type ion implantation is used to form the source and drain regions **26, 27,** depending upon the given implementation. The structure is then annealed and cleaned. Self-aligned silicide formation may then be performed to form the silicide layers **30, 31,** and **34,** and the source/drain contacts **32, 33,** are formed to provide the final semiconductor device **20** illustrated in FIG. 1. The silicide formation is also known as salicidation. The salicidation process includes metal deposition (e.g., Ti), nitrogen annealing, metal etching, and a second annealing.

The foregoing is, of course, but one example of a process and device in which the present invention may be used, and those of skill in the art will understand its application and use in many other processes and devices. In other processes and devices the structures of the present invention may be formed on a portion of a wafer or across substantially all of a wafer. Additionally, the use of an atomic layer deposition tool may also not be needed for forming the superlattice **25** in some embodiments. For example, the monolayers may be formed using a CVD tool with process conditions compatible with control of monolayers, as will be appreciated by those skilled in the art. Further details regarding fabrication of semiconductor devices in accordance with the present invention may be found in the above-noted U.S. patent application US2002/262,597, for example.

Many modifications and other embodiments of the invention will come to the mind of one skilled in the art having the benefit of the teachings presented in the foregoing descriptions and the associated drawings. Therefore, it is understood that the invention is not to be limited to the specific embodiments disclosed, and that modifications and embodiments are intended to be included within the scope of the appended claims.

**Claims**

1. A semiconductor device comprising:

   a semiconductor substrate; and
   at least one active device adjacent said semiconductor substrate and comprising

   an electrode layer,
   a high-K dielectric layer underlying said electrode layer and in contact therewith,
   a superlattice underlying said high-K dielectric layer opposite said electrode layer and in contact with said high-K dielectric layer, said superlattice comprising a plurality of stacked groups of layers, and being used as on insulator,
   each group of layers of said superlattice comprising a plurality of stacked base semiconductor monolayers defining a base semiconductor portion and at least one non-semiconductor monolayer constrained within a crystal lattice of adjacent base semiconductor portions, opposing base semiconductor monolayers in adjacent groups of layers of the superlattice being chemically bound together through said at least one non-semiconductor monolayer therebetween, and
   a channel region underlying said superlattice.

2. The semiconductor device of Claim 1 wherein said high-K dielectric layer has a dielectric constant of greater than about five.

3. The semiconductor device of Claim 1 wherein said high-K dielectric layer has a dielectric constant of greater than about ten.

4. The semiconductor device of Claim 1 wherein said high-K dielectric layer has a dielectric constant of greater than about twenty.

5. The semiconductor device of Claim 1 wherein said at least one non-semiconductor monolayer constrained within the crystal lattice of adjacent base semiconductor portions is less than about five monolayers to thereby function as an energy band-modifying layer.

6. The semiconductor device of Claim 1 wherein said at least one active device further comprises source and drain regions adjacent said channel region.

7. The semiconductor device of Claim 1 wherein said high-K dielectric layer comprises at least one of silicon oxide, zirconium oxide, and hafnium oxide.

8. The semiconductor device of Claim 1 wherein said base semiconductor comprises silicon.

9. The semiconductor device of Claim 1 wherein said at least one non-semiconductor monolayer comprises oxygen.

10. The semiconductor device of Claim 1 wherein said at least one non-semiconductor monolayer comprises a non-semiconductor selected from the group consisting essentially of oxygen, nitrogen, fluorine, and carbon-oxygen.

11. The semiconductor device of Claim 1 wherein said at least one non-semiconductor monolayer is a single monolayer thick.

12. The semiconductor device of Claim 1 wherein each base semiconductor portion is less than eight monolayers thick.

13. The semiconductor device of Claim 1 wherein all of said base semiconductor portions are a same number of monolayers thick.

14. The semiconductor device of Claim 1 wherein at least some of said base semiconductor portions are a different number of monolayers thick.

15. A method for making a semiconductor device comprising:

forming a superlattice comprising a plurality of stacked groups of layers overlying a channel region in a semiconductor substrate, said superlattice intended to be used as an insulator;
each group of layers of the superlattice comprising a plurality of stacked base semiconductor monolayers defining a base semiconductor portion and at least one non-semiconductor monolayer constrained within a crystal lattice of adjacent base semiconductor portions, and opposing base semiconductor monolayers in adjacent groups of layers of the superlattice being chemically bound together through said at least one non-semiconductor monolayer therebetween;
forming a high-K dielectric layer adjacent the superlattice; and
forming an electrode layer adjacent the thigh-K dielectric layer and opposite the superlattice.

16. The method of Claim 15 wherein the high-K dielectric layer has a dielectric constant of greater than about five.

17. The method of Claim 15 wherein the high-K dielectric layer has a dielectric constant of greater than about ten.

18. The method of Claim 15 wherein the high-K dielectric layer has a dielectric constant of greater than about twenty.

19. The method of Claim 15 wherein the at least one non-semiconductor monolayer constrained within the crystal lattice of adjacent base semiconductor portions is less than about five monolayers to thereby function as an energy band-modifying layer.

20. The method of Claim 15 further comprising forming source and drain regions adjacent the channel region.

21. The method of Claim 15 wherein the high-K dielectric layer comprises at least one of silicon oxide, zirconium oxide, and hafnium oxide.

**22.** The method of Claim 15 wherein the base semiconductor comprises silicon.

**23.** The method of Claim 15 wherein the at least one non-semiconductor monolayer comprises oxygen.

**24.** The method of Claim 15 wherein the at least one non-semiconductor monolayer comprises a non-semiconductor selected from the group consisting essentially of oxygen, nitrogen, fluorine, and carbon-oxygen.

**25.** The method of Claim 15 wherein the at least one non-semiconductor monolayer is a single monolayer thick.

**26.** The method of Claim 15 wherein each base semiconductor portion is less than eight monolayers thick.

**27.** The method of Claim 15 wherein all of the base semiconductor portions are a same number of monolayers thick.

**28.** The method of Claim 15 wherein at least some of the base semiconductor portions are a different number of monolayers thick.


**Patentansprüche**

**1.** Ein Halbleiterbauelement, das aufweist
ein Halbleitersubstrat; und
zumindest ein aktives Teil in der Nachbarschaft des Halbleitersubstrats und aufweisend

- eine Elektrodenschicht,
- eine dielektrische Lage mit hohem K-Wert, die unter der Elektrodenschicht ist und in Kontakt mit ihr ist,
- ein Übergitter, das unter der dielektrischen Lage mit hohem K-Wert ist, gegenüberliegend der Elektrodenschicht ist und in Kontakt mit der dielektrischen Lage mit hohem K-Wert ist, dieses Übergitter weist eine Vielzahl von geschichteten Gruppen von Lagen auf und wird als ein Isolator verwendet,

o jede Gruppe von Lagen des Übergitters weist eine Vielzahl von geschichteten Basishalbleitermonolagen auf, die einen Basishalbleiterbereich und zumindest eine Nichthalbleitermonolage definieren, die innerhalb eines Kristallgitters benachbarter Halbleiterbereiche eingezwängt ist, gegenüberliegende Basishalbleitermonolagen in benachbarten Gruppen von Lagen des Übergitters sind chemisch durch die zumindest eine Nichthalbleitermonolage zwischen ihnen miteinander verbunden und
o eine Kanalregion, die unter dem Übergitter liegt.

**2.** Das Halbleiterbauteil nach Anspruch 1, wobei die dielektrische Lage mit hohem K-Wert eine Dielektrizitätskonstante größer als etwa fünf hat.

**3.** Das Halbleiterbauteil nach Anspruch 1, wobei die dielektrische Lage mit hohem K-Wert eine Dielektrizitätskonstante größer als etwa zehn hat.

**4.** Das Halbleiterbauteil nach Anspruch 1, wobei die dielektrische Lage mit hohem K-Wert eine Dielektrizitätskonstante von größer als etwa 20 hat.

**5.** Das Halbleiterbauteil nach Anspruch 1, wobei die zumindest eine Nichthalbleitermonolage, die eingezwängt ist innerhalb des Kristallgitters benachbarter Basishalbleiterbereiche, weniger als etwa fünf Monolagen aufweist, um **dadurch** als eine Energieband modifizierende Lage zu wirken.

**6.** Das Halbleiterbauteil nach Anspruch 1, wobei das mindestens eine aktive Teil weiterhin Source- und Drain-Bereiche aufweist, die der Kanalregion benachbart sind.

**7.** Das Halbleiterbauteil nach Anspruch 1, wobei die dielektrische Lage mit hohem K-Wert mindestens ein Element ausgewählt aus Siliziumoxid, Zirkonoxid und Hafniumoxid aufweist.

**8.** Das Halbleiterbauteil nach Anspruch 1, wobei der Basishalbleiter Silizium aufweist.

**9.** Das Halbleiterbauteil nach Anspruch 1, wobei die zumindest eine Nichthalbleitermonolage Sauerstoff aufweist.

**10.** Das Halbleiterbauteil nach Anspruch 1, wobei die zumindest eine Nichthalbleitermonolage einen Nichthalbleiter aufweist, der ausgewählt ist aus der Gruppe, die im Wesentlichen aufweist Sauerstoff, Stickstoff, Fluor und Kohlenstoff-Sauerstoff.

**11.** Das Halbleiterbauteil nach Anspruch 1, wobei die zumindest eine Nichthalbleitermonolage eine einzige Monolage dick ist.

**12.** Das Halbleiterbauteil nach Anspruch 1, wobei jeder Basishalbleiterbereich weniger als acht Monolagen dick ist.

**13.** Das Halbleiterbauteil nach Anspruch1, wobei alle der genannten Basishalbleiterbereiche dieselbe Anzahl von Monolagen dick sind.

**14.** Das Halbleiterbauteil nach Anspruch 1, wobei zumindest einige der Basishalbleiterbereiche eine unterschiedliche Anzahl von Monolagen dick sind.

**15.** Ein Verfahren zum Herstellen eines Halbleiterbauteils, das aufweist:

Ausbilden eines Übergitters, das eine Vielzahl von geschichteten Gruppen von Lagen hat, die über einer Kanalregion in einem Halbleitersubstrat liegen, das Übergitter soll dabei als ein Isolator verwendet werden, jede Gruppe von Lagen des Übergitters hat eine Vielzahl von geschichteten Basishalbleitermonolagen, die einen Basishalbleiterbereich definieren und zumindest eine Nichthalbleitermonolage, die in einem Kristallgitter benachbarter Basishalbleiterbereiche eingezwängt ist, und gegenüberliegende Basishalbleitermonolagen in benachbarten Gruppen von Lagen des Übergitters sind chemisch miteinander gebunden durch die zumindest eine Nichthalbleitermonolage zwischen ihnen;
Ausbilden einer dielektrischen Lage mit hohem K-Wert in Nachbarschaft des Übergitters; und
Ausbilden einer Elektrodenschicht in Nachbarschaft der dielektrischen Lage mit hohem K-Wert und gegenüberliegend dem Übergitter.

**16.** Das Verfahren nach Anspruch 15, wobei die dielektrische Lage mit hohem K-Wert eine Dielektrizitätskonstante von größer als etwa fünf hat.

**17.** Das Verfahren nach Anspruch 15, wobei die dielektrische Lage mit hohem K-Wert eine Dielektrizitätskonstante von größer als etwa zehn hat.

**18.** Das Verfahren nach Anspruch 15, wobei die dielektrische Lage mit hohem K-Wert eine Dielektrizitätskonstante von größer als etwa zwanzig hat.

**19.** Das Verfahren nach Anspruch 15, wobei die zumindest eine Nichthalbleitermonolage, die eingezwängt ist innerhalb des Kristallgitters benachbarter Basishalbleiterbereiche, weniger als etwa fünf Monolagen aufweist, um **dadurch** als eine Energieband modifizierende Lage zu wirken.

**20.** Das Verfahren nach Anspruch 15, weiterhin aufweisend das Ausbilden von Source- und Drain-Bereichen, die der Kanalregion benachbart sind.

**21.** Das Verfahren nach Anspruch 15, wobei die dielektrische Lage mit hohem K-Wert mindestens ein Element ausgewählt aus Siliziumoxid, Zirkonoxid und Hafniumoxid aufweist.

**22.** Das Verfahren nach Anspruch 15, wobei der Basishalbleiter Silizium aufweist.

**23.** Das Verfahren nach Anspruch 15, wobei die zumindest eine Nichthalbleitermonolage Sauerstoff aufweist.

**24.** Das Verfahren nach Anspruch 15, wobei die zumindest eine Nichthalbleitermonolage einen Nichthalbleiter aufweist, der ausgewählt ist aus der Gruppe, die im Wesentlichen aufweist Sauerstoff, Stickstoff, Fluor und Kohlenstoff-Sauerstoff.

**25.** Das Verfahren nach Anspruch 15, wobei die zumindest eine Nichthalbleitermonolage eine einzige Monolage dick ist.

**26.** Das Verfahren nach Anspruch 15, wobei jeder Basishalbleiterbereich weniger als acht Monolagen dick ist.

**27.** Das Verfahren nach Anspruch15, wobei alle der genannten Basishalbleiterbereiche dieselbe Anzahl von Monolagen dick sind.

**28.** Das Verfahren nach Anspruch 15, wobei zumindest einige der Basishalbleiterbereiche eine unterschiedliche Anzahl von Monolagen dick sind.


**Revendications**

**1.** Dispositif semi-conducteur comprenant :

un substrat semi-conducteur ; et
au moins un dispositif actif qui est adjacent audit substrat semi-conducteur et qui comprend :

une couche d'électrodes,
une couche à permittivité K élevée, qui s'étend sous ladite couche d'électrodes et qui est au contact de celle-ci
un super-réseau qui s'étend sous ladite couche à permittivité K élevée, à l'opposé de ladite couche d'électrodes, et qui est au contact de ladite couche à permittivité K élevée, ledit super-réseau comprenant une pluralité de groupes de couches empilés, et étant adapté à être utilisé comme un isolant,
chaque groupe de couches dudit super-réseau comprenant une pluralité de mono-couches de base semi-conductrices empilées définissant une partie semi-conductrice de base, et au moins une mono-couche non semi-conductrice contrainte à l'intérieur d'un réseau cristallin des parties semi-conductrices de base adjacentes, les mono-couches de base semi-conductrices opposées appartenant aux groupes de couches adjacentes du super-réseau étant chimiquement liées ensemble au travers de ladite au moins une mono-couche non semi-conductrice qui s'interpose entre elles, et
une zone de canal s'étendant sous ledit super-réseau.

**2.** Dispositif semi-conducteur selon la revendication 1, dans lequel ladite couche à permittivité K élevée présente une permittivité relative supérieure à environ cinq.

**3.** Dispositif semi-conducteur selon la revendication 1, dans lequel ladite couche à permittivité K élevée présente une permittivité relative supérieure à environ dix.

**4.** Dispositif semi-conducteur selon la revendication 1, dans lequel ladite couche à permittivité K élevée présente une permittivité relative supérieure à environ vingt.

**5.** Dispositif semi-conducteur selon la revendication 1, dans lequel ladite au moins une mono-couche non semi-conductrice contrainte à l'intérieur du réseau cristallin des parties semi-conductrices de base adjacentes comporte moins d'environ cinq mono-couches pour fonctionner comme une couche modificatrice de bande énergétique.

**6.** Dispositif semi-conducteur selon la revendication 1, dans lequel ledit au moins un dispositif actif comprend en outre des zones de source et de drain qui sont adjacentes à ladite zone de canal.

**7.** Dispositif semi-conducteur selon la revendication 1, dans lequel ladite couche à permittivité K élevée comprend au moins un oxyde parmi l'oxyde de silicium, l'oxyde de zirconium et l'oxyde d'hafnium.

**8.** Dispositif semi-conducteur selon la revendication 1, dans lequel ladite partie semi-conductrice de base comprend du silicium.

**9.** Dispositif semi-conducteur selon la revendication 1, dans lequel ladite au moins une mono-couche non semi-conductrice comprend de l'oxygène.

**10.** Dispositif semi-conducteur selon la revendication 1, dans lequel ladite au moins une mono-couche non semi-conductrice comprend un élément non semi-conducteur sélectionné parmi le groupe essentiellement formé de l'oxygène, l'azote, le fluor et le monoxyde de carbone.

**11.** Dispositif semi-conducteur selon la revendication 1, dans lequel ladite au moins une mono-couche non semi-conductrice est formée d'une unique mono-couche épaisse.

**12.** Dispositif semi-conducteur selon la revendication 1, dans lequel chaque partie semi-conductrice de base est formée de moins de huit mono-couches épaisses.

**13.** Dispositif semi-conducteur selon la revendication 1, dans lequel toutes les parties semi-conductrices de base sont formées d'un même nombre de mono-couches épaisses.

**14.** Dispositif semi-conducteur selon la revendication 1, dans lequel au moins certaines des parties semi-conductrices de base sont formées d'un nombre différent de mono-couches épaisses.

**15.** Procédé de fabrication d'un dispositif semi-conducteur comprenant :

la formation d'un super-réseau comportant une pluralité de mono-couches de base semi-conductrices empilées s'étendant au-dessus d'une zone de canal d'un substrat semi-conducteur, ce super-réseau étant adapté à être utilisé comme un isolant ;
chaque groupe de couches du super-réseau comprenant une pluralité de mono-couches de base semi-conductrices empilées définissant une partie semi-conductrice de base, et au moins une mono-couche non semi-conductrice contrainte à l'intérieur d'un réseau cristallin des parties semi-conductrices de base adjacentes, les mono-couches de base semi-conductrices opposées appartenant aux groupes de couches adjacents du super-réseau étant chimiquement liées ensemble au travers de ladite au moins une mono-couche non semi-conductrice qui s'interpose entre elles ;
la formation d'une couche à permittivité K élevée adjacente au super-réseau ; et
la formation d'une couche d'électrodes adjacente à la couche à permittivité K élevée, située à l'opposé du super-réseau.

**16.** Procédé selon la revendication 15, dans lequel ladite couche à permittivité K élevée présente une permittivité relative supérieure à environ cinq.

**17.** Procédé selon la revendication 15, dans lequel ladite couche à permittivité K élevée présente une permittivité relative supérieure à environ dix.

**18.** Procédé selon la revendication 15, dans lequel ladite couche à permittivité K élevée présente une permittivité relative supérieure à environ vingt.

**19.** Procédé selon la revendication 15, dans lequel ladite au moins une mono-couche non semi-conductrice contrainte à l'intérieur du réseau cristallin des parties semi-conductrices de base adjacentes comporte moins d'environ cinq mono-couches pour fonctionner comme une couche modificatrice de bande énergétique.

**20.** Procédé selon la revendication 15, dans lequel ledit au moins un dispositif actif comprend en outre des zones de source et de drain qui sont adjacentes à ladite zone de canal.

**21.** Procédé selon la revendication 15, dans lequel ladite couche à permittivité K élevée comprend au moins un oxyde parmi l'oxyde de silicium, l'oxyde de zirconium et l'oxyde d'hafnium.

**22.** Procédé selon la revendication 15, dans lequel ladite partie semi-conductrice de base comprend du silicium.

**23.** Procédé selon la revendication 15, dans lequel ladite au moins une mono-couche non semi-conductrice comprend de l'oxygène.

**24.** Procédé selon la revendication 15, dans lequel ladite au moins une mono-couche non semi-conductrice comprend un élément non semi-conducteur sélectionné parmi le groupe essentiellement formé de l'oxygène, l'azote, le fluor et le monoxyde de carbone.

**25.** Procédé selon la revendication 15, dans lequel ladite au moins une mono-couche non semi-conductrice est formée d'une unique mono-couche épaisse.

**26.** Procédé selon la revendication 15, dans lequel chaque partie semi-conductrice de base est formée de moins de huit mono-couches épaisses.

27. Procédé selon la revendication 15, dans lequel toutes les parties semi-conductrices de base sont formées d'un même nombre de mono-couches épaisses.

28. Procédé selon la revendication 15, dans lequel au moins certaines des parties semi-conductrices de base sont formées d'un nombre différent de mono-couches épaisses.

**FIG. 1**

**FIG. 2**

**FIG. 3**

**FIG. 4**

18

FIG. 5A

4/1 SiO BAND STRUCTURE ABOUT Z POINT

FIG. 5B

FIG. 5C

36

37

25

21

## FIG. 6A

36

37

25

22

23

21

## FIG. 6B

FIG. 6C

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20030057416 A, Currie
- US 20030034529 A, Fitzgerald
- US 6472685 B2, Takagi
- US 4937204 A, Ishibashi
- US 5357119 A, Wang
- US 5683934 A, Candelaria
- US 5216262 A, Tsu
- WO 02103767 A1, Wang, Tsu and Lofgren
- GB 2347520 A, Mears
- US 2002262597 A

**Non-patent literature cited in the description**

- **Tsu.** Phenomena in silicon nanostructure devices. *Applied Physics and Materials Science & Processing,* 06 September 2000, 391-402
- **Luo et al.** Chemical Design of Direct-Gap Light-Emitting Silicon. *Physical Review Letters,* 12 August 2002, vol. 89 (7